# EUROPEAN PATENT APPLICATION

(11) **EP 4 723 401 A1**
(43) Date of publication of application: **08.04.2026**
(21) Application number: 24383058.5
(22) Date of filing: 01.10.2024
(51) Int. Cl.: H01S 5/10

(54) **DIFFUSIVE CAVITY SURFACE EMITTING LASER AND MANUFACTURING METHOD THEREOF**

(71) Applicant: Consejo Superior De Investigaciones Científicas (CSIC), 28006 Madrid (ES)
(72) Inventor: López Fernández, Ceferino, Madrid (ES); Consoli Barone, Antonio Rosario, Madrid (ES)
(74) Representative: Herrero & Asociados, S.L.

(57) **Abstract**

A surface emission random laser and a manufacturing method thereof, wherein the random laser comprises: a semiconductor die (1) comprising a plurality of semiconductor layers; two or more electrodes (2), attached to the semiconductor die (1) for current injection; an optically active layer (3) placed between two semiconductor layers to produce optical amplification as a response to the current injection; two planar confinement layers (4), arranged over and under the optically active layer (3) configured for light confinement; and one or more scattering elements (5), being holes or grooves drilled in the semiconductor die (1) and extending at least to reach the optically active layer (3) and defining scattering rough surfaces (7) divided into: a proximal scattering surface (8) for optical feedback; and a distal scattering surface (9) for light extraction (6).

## Description

### OBJECT OF THE INVENTION

The invention is referred to the field of semiconductor lasers, more precisely, to the field of surface emitting lasers.

The object of the invention is a diffusive cavity surface emitting laser (DCSEL) which allows to simplify and achieve the same effect than a surface-emitting laser with vertical cavity, reducing its complexity and manufacturing costs. Another object of the invention is a method for manufacturing the surface emitting random laser.

### BACKGROUND ART

The manufacture of semiconductor lasers is based on the flat technology of epitaxial growth. Thus, this manufacturing process commonly follows the steps of: growth, doping, chemical attack or etching, starting from a wafer of semiconductor material.

Semiconductor lasers are divided into two categories based on the direction of emission with respect to the direction of epitaxial growth:
(i) edge emitters emit through the wafer section in a direction perpendicular to the direction of growth, and
(ii) surface emitters emit from the wafer surface in the direction of growth.

Edge-emitting lasers require the wafer to be cut and diced in order to make each device and characterize them once the electrical contacts have been made, since the light is emitted by the wafer section.

On the contrary, in surface emitting lasers, this cutting step is not required for emission detection, as electrical contacts can be made in the wafer plane and the emitted light can be detected in the perpendicular direction.

In vertical cavity surface emission lasers ("VCSEL") the optical cavity extends in the vertical direction (the direction of epitaxial growth), and this requires complex manufacturing solutions. For example, the mirrors that form said cavity are distributed Bragg reflectors (DBRs) which needs a reflectivity greater than 99%. Also, the electrical contacts have to be transparent or to have a geometry that allows the propagation of the light beam, optimizing at the same time the flow of current and dissipation of the heat induced by the passage of the current. Thus, the surface emission lasers require a higher design cost compared to edge emitting lasers.

Vertical cavity surface emission lasers (VCSEL) currently cover different applications, such as, 3D image reconstruction in mobile phones, augmented reality, fiber optic communications, LIDAR for cars, gas detection, or high-power emission in 2D arrays, among others. Nevertheless, the market of vertical cavity surface emission lasers (VCSEL) will increase in the following years.

VCSELs also allow direct integration with other optoelectronic devices, optimize fiber optic coupling, allow the creation of 2D arrays and also lower testing and characterization costs in the production phase.

### DESCRIPTION OF THE INVENTION

The present invention discloses a diffusive cavity surface emitting laser (DCSEL) based on a planar optical cavity similar to that of edge emitting lasers. The diffusive cavity surface emitting laser of the invention allows to obtain the advantages of VCSELs at a reduced complexity and fabrication cost.

The diffusive cavity surface emitting laser of the invention achieves surface emission without the need of a vertical cavity based on DBRs, which require a complex and costly manufacturing process. In the diffusive cavity surface emitting laser of the invention, the feedback required for lasing is provided by scattering surfaces.

The diffusive cavity surface emitting laser of the invention comprises a semiconductor die comprising a plurality of semiconductor layers. The semiconductor die, in electronic and optoelectronic fields, is a block of semiconducting material manufactured by epitaxial growth, i.e. layer by layer. Thus, this semiconductor die comprises a plurality of semiconductor layers, which could be of the type: n-layer or p-layer. Preferably, in the present invention, the semiconductor die could have dimensions in the range of tens to hundreds of micrometers.

The diffusive cavity surface emitting laser (DCSEL) of the invention also comprises two or more electrodes, contacting the semiconductor die, which provide electrical pumping via current injection. The two or more electrodes could act as anodes and/or cathodes. In this case, the electrodes are metallic and could be gold-plated, as in standard manufacture process of optoelectronics emitters based on semiconductors.

Also, the laser of the invention comprises an optically active layer and two confinement layers in the semiconductor die, a first confinement layer and a second confinement layer. The active layer preferably could have a thickness in the range of nanometers and a width and a length in the range of tens or hundreds of micrometers.

The semiconductor die, thus, comprises an active layer place between two sets of electronic confinement layers which are in turn, placed between two photonic confinement layers.

Electronic confinement can be provided for example by p-n junctions, heterojunctions or quantum wells. The photonic confinement layers are configured to produce light confinement by total internal reflection. Preferably, the confinement layers are n-layers or p-layers with lower refractive index.

In this way, the optically active layer is configured to produce optical amplification as a response to the current injection. The optically active layer could be made of p-n junctions, hetero-junctions or multiple quantum wells or any suitable combination thereof.

Preferably, the optically active layer is made of alloys of semiconductor and the specific material is selected by the desired emission wavelength. For example, InAIGaAs materials could be selected for red and GaN for blue.

The laser of the invention comprises also one or more scattering elements.

The scattering elements are holes and/or grooves drilled in the semiconductor die and extending along the epitaxial growth direction, through the confinement layers and reaching, at least, the optically active layer.

The scattering elements could define:
- one scattering rough surface surrounding at least one of the electrodes, or
- a plurality of scattering rough surfaces arranged at opposite ends of at least one of the electrodes.

The scattering rough surfaces are rough interfaces defined between two volumes of materials with different refractive indexes, such as the active layer and air.

Also, each scattering rough surface being divided into:
- a proximal scattering surface bounding the optically active layer; and configured to provide optical feedback by scattering back emitted light into the active layer; and
- a distal scattering surface in contact with the semiconductor layers of the semiconductor die and configured to provide light extraction into the vertical direction after multiple scattering inside the scattering rough element.

The distal scattering surface could also be in contact with the confinement layers.

Therefore, the diffusive cavity surface emitting laser (DCSEL) of the invention comprises a planar optical cavity, like in the case of edge emitting lasers, defined by the scattering elements and the confinement layers. The planar optical cavity of the laser of the invention has a simpler and cheaper design than VCSELs since they allow to provide optical feedback and vertical emission without using DBRs, using the holes and/or grooves instead.

The random laser of the invention allows the realization of emission patterns with arbitrary geometries which depend on the shape and arrangement of the grooves and/or holes which define the scattering elements.

The random laser of the invention can be a single emitter realized on the semiconductor die or multiple emitters on the same semiconductor die.

As a single emitter, the diffusive cavity surface emitting laser (DCSEL) of the invention has one pair of electrodes (anode and cathode).

The geometry of the diffusive cavity surface emitting laser (DCSEL) of the invention as a single emitter can consists of a groove surrounding at least one of the electrodes. The groove could have a circular, rectangular or other shape.

Alternatively, the scattering elements of the diffusive cavity surface emitting laser (DCSEL) of the invention, as a single emitter, can be a plurality of holes or a plurality of grooves, defining a plurality of scattering rough surfaces located at opposite ends of at least one of the electrodes.

In the multiple emitters' configuration, said emitters can share the optically active layer, the confinement layers and/or at least one electrode. Preferably, in this configuration, each electrode is configured to provide an independent synchronous or asynchronous current injection.

Additionally, two or more of the plurality of emitters could share at least part of the scattering rough surfaces. For example, two or more of the plurality of emitters could share at least one of the holes or grooves.

In the present invention, each emitter comprises a pair of anode and cathode electrodes, an active layer, the confinement layers and the scattering surface for providing the light emission. Nevertheless, as explained, a common cathode and multiple anodes or a common anode and multiple cathodes can be used. In this case, each emitter is delimited by the scattering elements which provide light emission.

Therefore, current could be injected independently into an area of the active layer affecting only the scattering elements of the emitter in said area.

In the multiple emitters configuration of the diffusive cavity surface emitting laser (DCSEL) of the invention, two or more of the plurality of emitters could share one hole, being one of the electrodes of each emitter positioned in a radial or network configuration, and each emitter comprising other hole located at opposite ends of the electrode. Other network configurations could be used.

As multiple emitters on the same semiconductor die, the diffusive cavity surface emitting laser (DCSEL) of the invention could be used, for example, for the creation of photonic neural networks for complex signal processing with reservoir computing.

The vertical emission can be advantageous in LIDAR related applications as for VCSEL, which are the preferred optical source for automotive and face recognition LIDAR based applications.

The diffusive cavity surface emitting laser (DCSEL) of invention can be competitive in lighting and imaging applications due to the low spatial coherence, characteristic of random lasers, and higher energy efficiency compared to LEDs.

The invention also relates to a method for manufacturing a surface emission random laser comprising the steps of:
- fabricating an active layer placed between the corresponding optical and electronic confinement layers;
- connecting one or more electrodes to the semiconductor die;
- drilling one or more holes and/or grooves in the semiconductor die extending at least to the optically active layer and defining one scattering rough surface surrounding at least the foot-print of one of the electrodes or a plurality of scattering rough surfaces located at opposite ends of at least one of the electrodes.

### DESCRIPTION OF THE DRAWINGS

Figure 1. Shows a schematic view of a preferred embodiment of a single emitter configuration of the diffusive cavity surface emitting laser (DCSEL) of the invention.
Figure 2. Shows a schematic view of a preferred embodiment of a multiple emitters in a chain configuration of the diffusive cavity surface emitting laser (DCSEL) of the invention.
Figure 3. Shows exemplary embodiments of the diffusive cavity surface emitting laser (DCSEL) of the invention, in a single emitter configuration: comprising as scattering elements, two holes (a), a circular groove (b) a square groove (c); and in a multiple emitters configuration: comprising multiple holes in a radial shape.

### PREFERRED EMBODIMENTS OF THE INVENTION

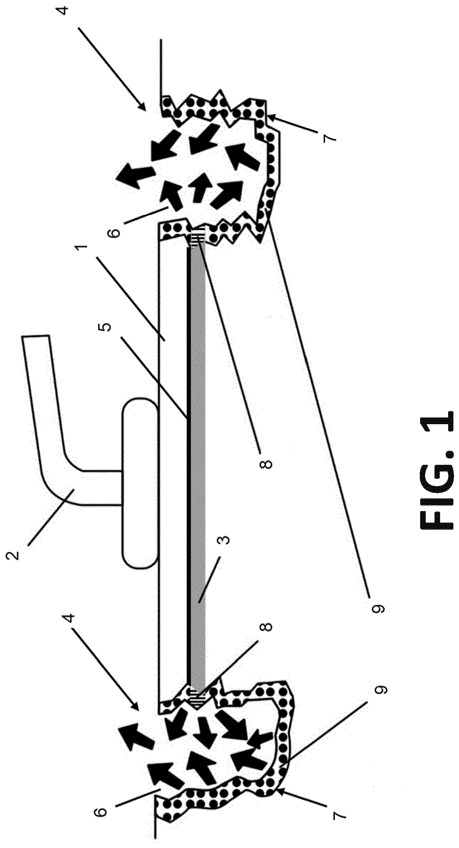

In Figure 1, a cross section of the diffusive cavity surface emitting laser (DCSEL) of the invention in the single emitter configuration is shown. The diffusive cavity surface emitting laser (DCSEL) of the invention comprises: a semiconductor die (1), one pair of anode and cathode electrodes (2), attached to the semiconductor die (1), for current injection; and an optically active layer (3) placed between two confinement layers (4) inside the semiconductor die (1).

The diffusive cavity surface emitting laser (DCSEL) of the invention comprises at least two scattering elements (5), which are holes or grooves (5) drilled in the z-axis direction in the semiconductor die (1) and extending through the optical confinement layers (4) and the optically active layer (3).

The scattering elements provide optical feedback for lasing emission and allow light (black arrows in Fig. 1) extraction (6) in the vertical direction (z-axis) via the scattering rough surfaces (7) of the holes or grooves (5). The scattering rough surfaces (7) of the holes or grooves (5) are divided into:
- Proximal scattering surface (8), which is defined as the surface between the active layer (3) and the hole or groove (5). The proximal scattering surface (8) provides optical feedback through the back scattered light from the proximal scattering surface (8) into the active layer (3).
- Distal scattering surface (9), which is defined as the surface of the hole or groove (5) in the semiconductor die (1) which is not intersecting the electrically pumped active layer (3). The distal scattering surface (9) provides light extraction (6) in the vertical direction (z-axis) by multiple scattering inside the hole or groove (5) of the lasing light emitted by the active layer (3) from the proximal scattering surface (8).

The active layer (3) and the confinement layers (4) can extend outside the holes or grooves (5) in the x-axis and y-axis directions, as these elements are fabricated by epitaxial growth on the entire semiconductor die (1). Nevertheless, for the diffusive cavity surface emitting laser (DCSEL) of the invention, the region of active layer (3) and confinement layers (4) which are relevant are the ones provided with current flow through anode and cathode electrodes (2).

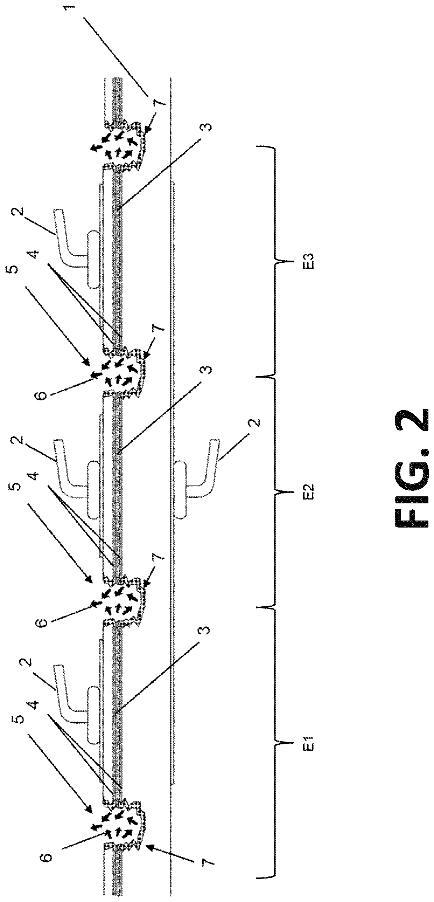

In Figure 2, a cross section of the diffusive cavity surface emitting laser (DCSEL) of the invention in a configuration of multiple emitters fabricated on the same semiconductor die (1) is shown. In Fig. 2, we show an example with three emitters, indicated as E1, E2 and E3. Each emitter consists of the same elements described in Fig. 2 for a single emitter: the active layer (3), the confinement layers (4), the hole or grooves (5) and the electrodes (2).

In the multiple emitters' configuration, certain holes or grooves (5) perform an additional function apart from giving feedback to the single emitter and light extraction (6) in the vertical direction, as they provide mutual optical coupling between adjacent emitters. This occurs because a portion of the scattered light inside the holes or groove (5) enters the active layer (3) of an adjacent emitter. Coupled lasers allows greater output power, richer spectral content and complex temporal dynamics with respect to solitary lasers.

In the multiple emitters' configuration shown in Fig. 2, each emitter is current biased and controlled independently from the others with multiple anodes and single cathode electrical contacts (2). Alternative electrical configurations consist of multiple anode and multiple cathodes, or single anode and multiple cathodes, for example.

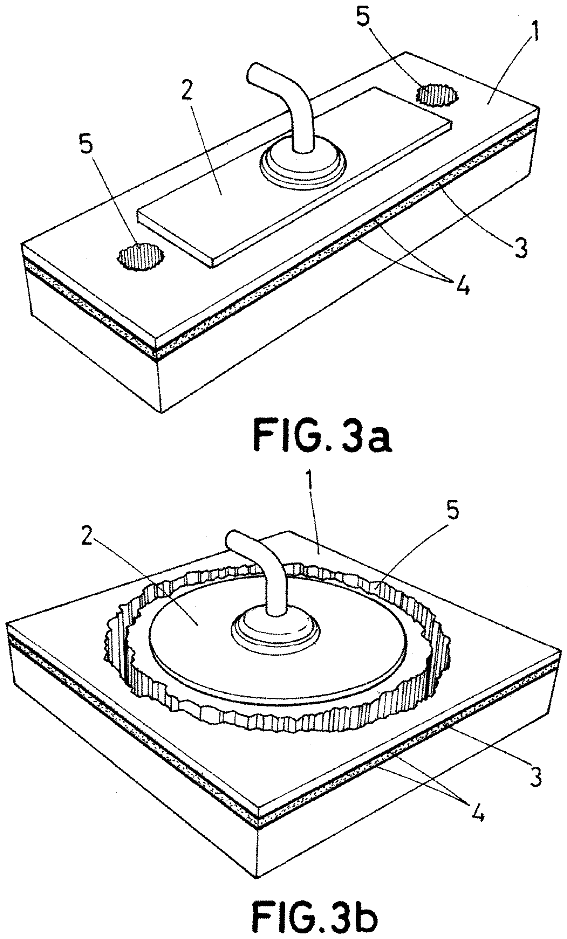

Figures 3a-3d show four different embodiments of the diffusive cavity surface emitting laser (DCSEL) of the invention.

Figure 3a shows a diffusive cavity surface emitting laser (DCSEL) comprising two holes (5) as scattering elements. In this embodiment, the two holes (5) are arranged at both ends of one electrode (2).

Figure 3b shows a second embodiment of the diffusive cavity surface emitting laser (DCSEL) comprising a circular groove (5) surrounding one electrode (2).

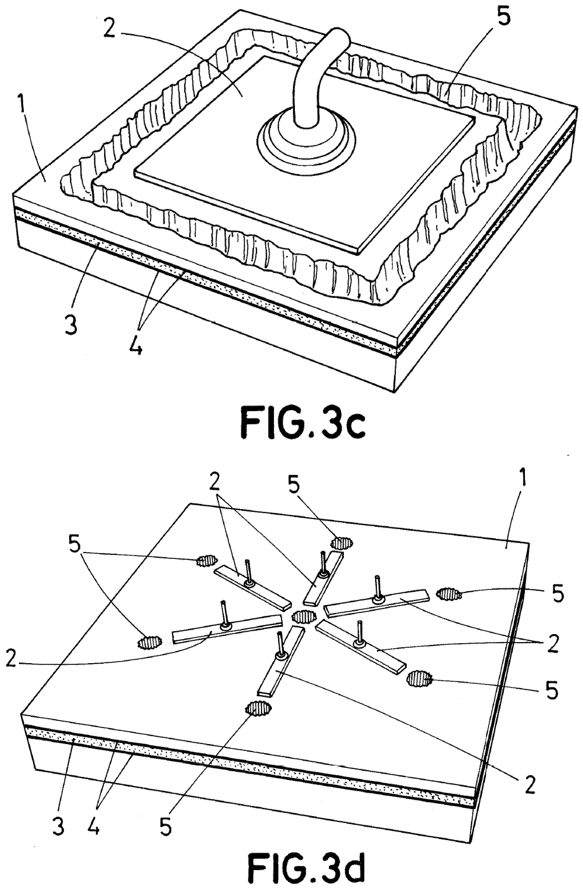

Figure 3c shows a third embodiment of the diffusive cavity surface emitting laser (DCSEL) comprising a squared groove (5) surrounding one electrode (2).

The three embodiments shown in Figures 3a, 3b and 3c demonstrate that the diffusive cavity surface emitting laser (DCSEL) of the invention allows the realization of emission patterns with arbitrary geometries.

Figure 3d shows a fourth embodiment of the diffusive cavity surface emitting laser (DCSEL) of the invention. In this case, the diffusive cavity surface emitting laser (DCSEL) comprises multiple emitters. The emitters share one hole (5) at the center of the star shape and the other holes (5) are arranged in a radial configuration. One electrode (2) of each emitter is arranged between the shared hole (5) and one of the holes (5) in radial configuration.

## Claims

1. A diffusive cavity surface emitting laser (DCSEL) comprising one or more emitters, each emitter comprising:
- a semiconductor die (1) comprising a plurality of semiconductor layers;
- two or more electrodes (2), attached to the semiconductor die (1) for current injection;
- an optically active layer (3) of the semiconductor die (1) and configured to produce optical amplification by current injection;
- two confinement layers (4), configured for light confinement, a first confinement layer arranged over the optically active layer (3) and a second confinement layer arranged under the optically active layer (3), and wherein the optically active layer (3) and the two confinement layers (4) are placed between two semiconductor layers of the semiconductor die (1); and
- one or more scattering elements (5), being holes and/or grooves, drilled in the semiconductor die (1) and extending through the confinement layers (4) and reaching, at least, the optically active layer (3), which define one scattering rough surface (7) surrounding at least one of the electrodes (2) or a plurality of scattering rough surfaces (7) located at opposite ends of at least one of the electrodes (2), each scattering rough surface (7) divided into:
• a proximal scattering surface (8) bounding the optically active layer (3); and configured to provide optical feedback; and
• a distal scattering surface (9) in contact with the semiconductor layers of the semiconductor die (1) and configured to provide light extraction.

2. The diffusive cavity surface emitting laser (DCSEL) according to claim 1, wherein the scattering elements (4) are grooves surrounding at least one of the electrodes (2).

3. The diffusive cavity surface emitting laser (DCSEL) according to claim 1, wherein the scattering elements (4) are a plurality of holes or a plurality of grooves, defining a plurality of scattering rough surfaces (7) located at opposite ends of at least one of the electrodes (2).

4. The diffusive cavity surface emitting laser (DCSEL) according to any of previous claims, comprising a plurality of emitters which share the optically active layer (3), the confinement layers (4) and/or at least one electrode (2).

5. The diffusive cavity surface emitting laser (DCSEL) according to claim 4, wherein each electrode (2) is configured to provide an independent synchronous or asynchronous current injection.

6. The diffusive cavity surface emitting laser (DCSEL) according to claim 2 and any of claims 4 to 5, wherein two or more of the plurality of emitters share part of the scattering rough surface (7).

7. The diffusive cavity surface emitting laser (DCSEL) according to claim 3 and any of claims 4 to 5, wherein two or more of the plurality of emitters share at least one of the holes or grooves.

8. The diffusive cavity surface emitting laser (DCSEL) according to claim 7, wherein two or more of the plurality of emitters share one hole, being one of the electrodes of each emitter positioned in a radial or network configuration, and each emitter comprising other hole located at an opposite end of the electrode (2).

9. The diffusive cavity surface emitting laser (DCSEL) according to any of claims 1 to 8, wherein the optically active layer (3) is made of alloys of semiconductor.

10. The diffusive cavity surface emitting laser (DCSEL) according to claim 9, wherein the optically active layer (3) is made of p-n junctions, hetero-junctions or multiple quantum wells or quantum dots.

11. The diffusive cavity surface emitting laser (DCSEL) according to any of claims 1 to 10, wherein the semiconductor die (1) has dimensions in the range of tens to hundreds of micrometers.

12. The diffusive cavity surface emitting laser (DCSEL) according to any of claims 1 to 11, wherein the optically active layer (3) has a thickness in the range of nanometers and a width and a length in the range of tens or hundreds of micrometers.

13. The diffusive cavity surface emitting laser (DCSEL) according to any of claims 1 to 12, wherein the semiconductor die (1) comprises n-layers and p-layers and the optically active layer (3) and the confinement layers (4) are positioned between a n-layer and a p-layer.

14. A manufacturing method for a diffusive cavity surface emitting laser (DCSEL) according to any of claims 1 to 13, comprising the steps of:
- providing a semiconductor die (1) comprising a plurality of semiconductor layers, an optically active layer (3) and two confinement layers (4), arranged over the optically active layer (3) and under the optically active layer (3), being the optically active layer (3) and two confinement layers (4) arranged between two semiconductor layers of the semiconductor die (1) respectively;
- connecting one or more electrodes (2) to the semiconductor die (1);
- drilling one or more holes and/or grooves in the semiconductor die (1) extending at least to the optically active layer (3), and defining one scattering rough surface (7) surrounding at least the foot print of one of the electrodes (2) or a plurality of scattering rough surfaces (7) located at opposite ends of at least one of the electrodes (2).
